# EUROPÄISCHE PATENTSCHRIFT

(11) **EP 2 467 001 B1**
(45) Veröffentlichungstag und Bekanntmachung des Hinweises auf die Patenterteilung: **27.08.2014**
(21) Anmeldenummer: 11188754.3
(22) Anmeldetag: 11.11.2011
(51) Int. Cl.: H05K 1/14

(54) **Schaltungsanordnung mit mindestens zwei Teilmoduln**
Circuit assembly with at least two sub-modules
Agencement de commutation doté d'au moins deux modules partiels

(30) Priorität: 17.12.2010 DE 102010063387
(43) Veröffentlichungstag der Anmeldung: 20.06.2012
(73) Patentinhaber: SEMIKRON Elektronik GmbH & Co. KG, 90431 Nürnberg (DE)
(72) Erfinder: Beckedahl, Peter, 90522 Oberasbach (DE); Bogen, Ingo, 90425 Nürnberg (DE); Ehler, Ralf, 91459 Markt Erlbach (DE); Knebel, Markus, 90587 Tuchenbach (DE)

(56) Entgegenhaltungen:
- EP-A2- 1 239 710
- WO-A1-2007/079534
- US-A1- 2001 015 887
- US-A1- 2004 246 662
- US-A1- 2005 233 611
- US-A1- 2006 119 761
- US-B1- 7 291 023

## Beschreibung

Die Erfindung betrifft eine Schaltungsanordnung mit mindestens zwei Teilmoduln, die in einem Gehäuse nebeneinander angeordnet sind, wobei jedes Teilmodul ein Substrat mit Leiterbahnen und mindestens ein hierauf angeordnetes Halbleiterbauelement aufweist, und zur schaltgerechten Kontaktierung des mindestens einen Halbleiterbauelementes eine Verbindungseinrichtung vorgesehen ist.

Die DE 10 2006 027 482 B3 offenbart eine Schaltungsanordnung mit einem Substrat mit Leiterbahnen und hierauf schaltungsgerecht angeordneten Halbleiterbauelementen, und mit einer Verbindungseinrichtung, die aus einem Folienverbund aus mindestens zwei elektrisch leitenden Schichten mit jeweils einer dazwischen angeordneten isolierenden Schicht besteht. Mindestens eine der elektrisch leitenden Schichten ist strukturiert und bildet Leiterbahnen aus. Mindestens eine elektrisch leitende Schicht weist erste Kontakteinrichtungen zu Anschlußflächen der Halbleiterbauelemente auf. Mindestens ein Teil dieser und/oder einer weiteren elektrisch leitenden Schicht bildet ein Teil mindestens einer zweiten Kontakteinrichtung zur reversiblen Verbindung mit einer externen Zuleitung. Die zweite Kontakteinrichtung weist mindestens ein Federelement mit einem Widerlager eines Gehäuses und/oder mindestens eine Feststellschraube auf.

Die DE 10 2009 024 385 beschreibt ein Leistungshalbleitermodul mit einem Substrat, einer Verbindungseinrichtung und mit Lastanschlußelementen, wobei auf einer Leiterbahn des Substrates mindestens ein Halbleiterbauelement angeordnet und schaltungsgerecht mittels der Verbindungseinrichtung aus einer Schichtfolge mit einer strukturierten ersten elektrisch leitenden Metallfolie, einer elektrisch isolierenden Folie und einer strukturierten zweiten elektrisch leitenden Folie mit mindestens einem Lastanschlußelement verbunden ist, wobei mindestens eine erste Leiterbahn eine Kontaktfläche aufweist, die mit einem Lastanschlußelement stoffschlüssig verbunden ist, und wobei die Verbindungseinrichtung Hilfskontakt-Anschlußflächen aufweist, die mit einer externen Leiterplatte verbindbar sind.

Aus der WO 2007/079534 A1 ist ein Untersystem für eine Computereinrichtung bekannt, die mehrere auf einen faltbaren Substrat angeordnete Chips aufweist.

Aus der US 2004/0246662 A1 ist ein Powermodul für Hochfrequenzschaltsysteme bekannt, bei dem ein eine ebene Fläche aufweisender Kühlkörper mit einer auf einer keramischen Schicht angeordneten metallischen Schicht verlötet ist.

Aus der US 2006/0119761 A1 ist ein Display mit einem Rahmen und einer Leiterplatte bekannt.

Aus der 2005/0233611 A1 ist eine Signalübertragungseinrichtung, die eine erste und ein zweite flexible Leiterplatte aufweist, bekannt.

Aus der DE 20 2008 052 029 A1 ist ein Halbleitermodul bekannt, das wenigstens einen Halbleiterchip, der auf einem Trägersubstrat angeordnet ist, aufweist. Das Halbleitermodul hat ein Gehäuse in dem das Trägersubstrat und eine Platine übereinander angeordnet sind, wobei die Platine eine sichere galvanische Trennung aufweist.

Bei Schaltungsanordnungen mit mindestens zwei Teilmoduln, die in einem Gehäuse nebeneinander angeordnet sind, ergibt sich für die Anbindung der Hilfskontakte an eine gemeinsame Leiterplatte zwischen dem jeweiligen Teilmodul und der Leiterplatte eine kritische Toleranz-Kette.

Der Erfindung liegt deshalb die Aufgabe zugrunde, eine Schaltungsanordnung der eingangs genannten Art zu schaffen, wobei die erwähnte kritische Toleranz-Kette zwischen den Teilmoduln und der gemeinsamen Leiterplatte eliminiert ist.

Diese Aufgabe wird erfindungsgemäß durch die Merkmale des Anspruches 1 gelöst. Bevorzugte Aus- bzw. Weiterbildungen der erfindungsgemäßen Schaltungsanordnung sind in den Unteransprüchen gekennzeichnet.

Erfindungsgemäß weist die Verbindungseinrichtung, zu dem jeweiligen Teilmodul zugehörig, mindestens eine Kontaktfahne mit Kontakten zur Kontaktierung mit Kontaktorganen der gemeinsamen Leiterplatte auf. Jedes Teilmodul weist einen Rahmen auf, der das zugehörige Substrat umschließt. Der Rahmen besteht vorzugsweise aus einem elektrisch isolierenden Material. An dem jeweiligen Rahmen ist mindestens ein Hilfsträger begrenzt beweglich vorgesehen, an dem die zugehörige Kontaktfahne befestigt ist. Diese Befestigung kann durch einen Formschluß und/oder durch einen Kraftschluß und/oder durch einen Materialschluß realisiert sein.

Der mindestens eine Hilfsträger für die zugehörige Kontaktfahne der jeweiligen Verbindungseinrichtung weist mindestens ein Positionierelement auf, das zur positionsgenauen Ausrichtung der Kontakte der entsprechenden Kontaktfahne relativ zu den Kontaktorganen der Leiterplatte vorgesehen ist, wenn die Leiterplatte an der erfindungsgemäßen Schaltungsanordnung angeordnet wird. Mit Hilfe der Positionierelemente werden die Hilfsträger mit den an ihnen befestigten Kontaktfahnen der flexiblen Verbindungseinrichtungen der Teilmodule genau richtig in Bezug zu den Kontaktorganen der Leiterplatte ausgerichtet, wenn diese an der Schaltungsanordnung angebracht und mit den Teilmoduln kontaktiert wird.

Erfindungsgemäß ist der mindestens eine Hilfsträger am Rahmen des entsprechenden Teilmoduls in Rahmen-Längsrichtung begrenzt beweglich. Außerdem ist der mindestens eine Hilfsträger am Rahmen auch senkrecht zur Rahmen-Längsrichtung begrenzt beweglich.

Der jeweilige Hilfsträger weist für die zugehörige Kontaktfahne zweckmäßigerweise eine ebene Auflagefläche auf, um zu den Kontaktorganen der Leiterplatte ein definiertes Gegenlager zu bilden. Zweckmäßig kann es sein, wenn zwischen dem mindestens einen Hilfsträger und der zugehörigen Kontaktfahne der flexiblen Verbindungseinrichtung des jeweiligen Teilmoduls ein flexibles Polsterelement vorgesehen ist, durch das der Kontakt-Anpreßdruck zwischen den Kontakten der Kontaktfahne und den Kontaktorganen der den Teilmoduln zugeordneten Leiterplatte weiter verbessert wird.

Das mindestens eine Positionierelement des jeweiligen Hilfsträgers ist vorzugsweise stiftförmig mit einem sich verjüngenden Zentrierabschnitt ausgebildet. Mit Hilfe des Zentrierabschnittes erfolgt automatisch eine Selbstzentrierung des jeweiligen Hilfsträgers in Bezug zur gemeinsamen Leiterplatte und somit eine Selbstzentrierung der Kontakte der Kontaktfahnen der flexiblen Verbindungseinrichtungen der Teilmodule in Bezug zu den zugehörigen Kontaktorganen der gemeinsamen Leiterplatte.

Die Hilfsträger der Teilmodule weisen zur Befestigung der gemeinsamen Leiterplatte zweckmäßigerweise Befestigungsorgane auf. Bei den Befestigungsorganen handelt sich beispielsweise um Gewindebuchsen, die zur Schraubbefestigung der Leiterplatte vorgesehen sind. Die Befestigungsorgane können z.B. auch als Schnapp-Rast-Elemente, als Klemmelemente o.dgl. ausgebildet sein.

Grundsätzlich wäre es auch möglich, den Erfindungsgedanken bei einem einzigen Modul anstelle mindestens zweier Teilmodule anzuwenden.

Weitere Einzelheiten, Merkmale und Vorteile ergeben sich aus der nachfolgenden Beschreibung in Verbindung mit den anliegenden Zeichnungen.

Es zeigen:
Figur 1 ein Teilmodul der Schaltungsanordnung in einer perspektivischen Ansicht,
Figur 2 schematisch abschnittweise in einer Seitenansicht wesentliche Einzelheiten eines Teilmoduls sowie einer davon beabstandet gezeichneten Leiterplatte, und
Figur 3 eine der Figur 2 ähnliche schematische Darstellung einer Ausbildung mit einem Polsterelement zwischen der Kontaktfahne und dem Hilfsträger.

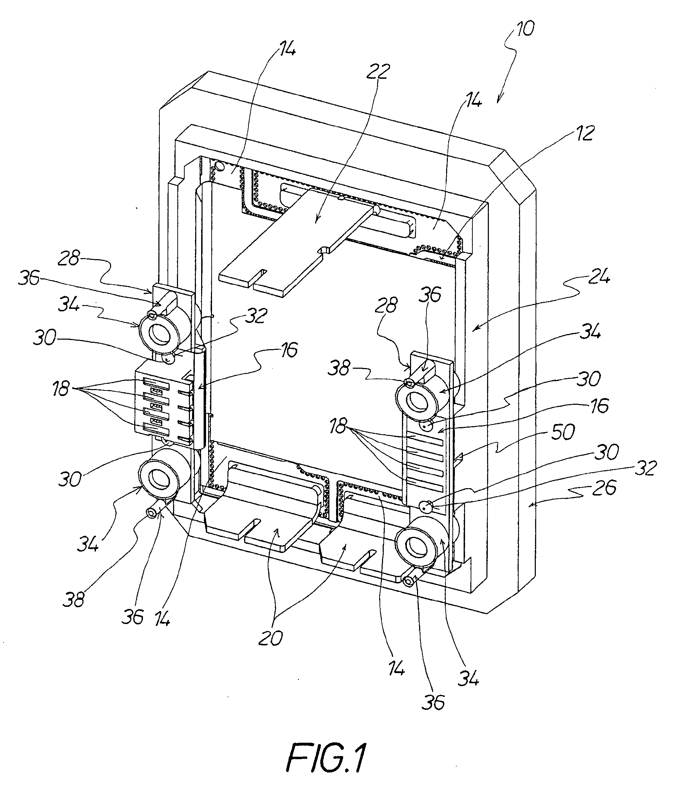

Figur 1 zeigt ein Teilmodul 10 einer erfindungsgemäßen Schaltungsanordnung, die in einem nicht gezeichneten Gehäuse nebeneinander mindestens zwei solche Teilmodule aufweist. Das jeweilige Teilmodul 10 weist ein Substrat 12 mit Leiterbahnen 14 und hierauf angeordneten (nicht gezeichneten) Halbleiterbauelementen auf. Zur Kontaktierung der Halbleiterbauelemente ist eine Verbindungseinrichtung vorgesehen, die Kontaktfahnen 16 mit Kontakten 18 aufweist. Bei den Kontakten 18 handelt es sich z.B. um Hilfskontakte des Teilmoduls 10. Mit der Bezugsziffer 20 sind Gleichstrom-Lastanschlüsse und mit der Bezugsziffer 22 ist ein Wechselstrom-Lastanschluß des Teilmoduls 10 bezeichnet. Das Teilmodul 10 bildet somit beispielsweise einen Umrichter. Selbstverständlich kann es sich bei dem Teilmodul 10 auch um ein Teilmodul für eine andere Schaltungsanordnung handeln.

Das Teilmodul 10 weist einen Rahmen 24 auf, der das zugehörige Substrat 12 umschließt. Der Rahmen 24 besteht aus einem elektrisch isolierenden Material, er steht von einem Kühlkörper 26 des Teilmoduls 10 nach oben. Der Kühlkörper 26 besteht aus Metall, beispielsweise aus Aluminium oder einer Aluminiumlegierung.

Am Rahmen 24 sind einander gegenüberliegend zwei Hilfsträger 28 begrenzt beweglich in Längsrichtung des Rahmens 24 und hierzu senkrecht, d.h. quer zur Rahmenlängsrichtung begrenzt beweglich vorgesehen. Die Kontaktfahne 16 der Verbindungseinrichtung ist am zugehörigen Hilfsträger 28 befestigt. Zu diesem Zwecke stehen von der ebenen Oberseite des jeweiligen Hilfsträgers 28 materialeinstückig Zapfen 30 weg, die sich durch Löcher 32 erstrecken, die in der jeweiligen Kontaktfahne 16 ausgebildet sind. Zur Fixierung der Kontaktfahne 16 am zugehörigen Hilfsträger 28 sind die Zapfe 30 beispielsweise heiß verstemmt.

Die Befestigung der Kontaktfahnen 16 an den jeweils zugehörigen Hilfsträgern 28 kann beispielsweise auch durch Verrastung, durch Festklemmen o.dgl. erfolgen.

Vom jeweiligen Hilfsträger 28 stehen materialeinstückig außerdem Befestigungsorgane 34 für die Leiterplatte und stiftförmige Positionierelemente 36 weg. Die Befestigungsorgane sind als Gewindebuchsen ausgebildet. Die Positionierelemente 36 sind mit verjüngten Zentrierabschnitten 38 ausgebildet. Die Zentrierabschnitte 38 können konisch, ballig oder beliebig anders verjüngt geformt sein.

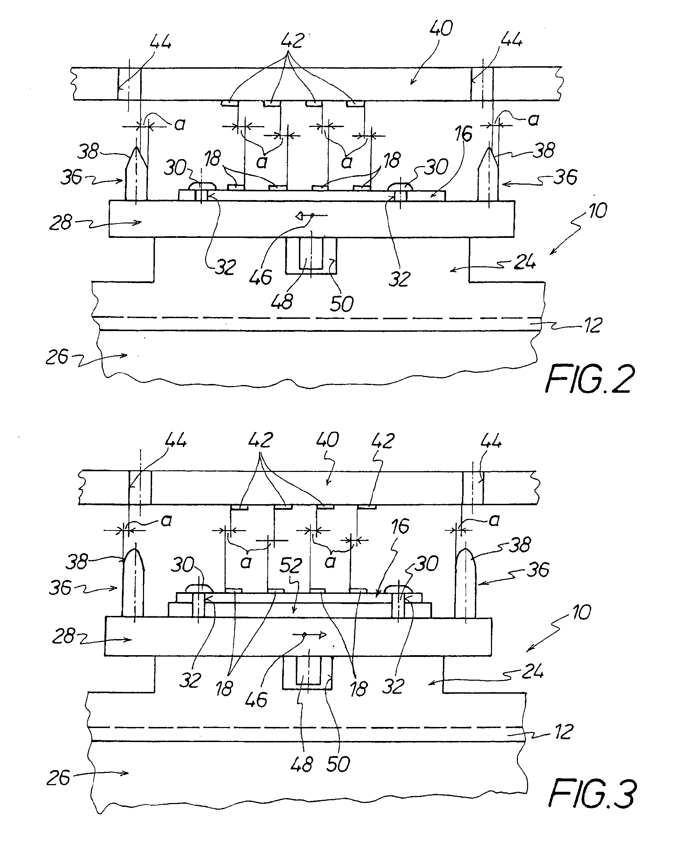

Die Funktionsweise der vom jeweiligen Hilfsträger 28 wegstehenden Positionierelemente 36 ist in Figur 2 verdeutlicht. In dieser Figur sind außerdem abschnittweise der Kühlkörper 26, das Substrat 12, der vom Kühlkörper 26 wegstehende und das Substrat 12 umschließende Rahmen 24 sowie eine Kontaktfahne 16 einer nicht gezeichneten Verbindungseinrichtung mit den Kontakten 18 schematisch dargestellt. Außerdem ist abschnittweise eine Leiterplatte 40 mit zu den Kontakten 18 zugehörigen Kontaktorganen 42, vom Teilmodul 10 beabstandet, gezeichnet. Die Leiterplatte 40 ist mit Löchern 44 ausgebildet, deren lichter Querschnitt an den Querschnitt der stiftförmigen Positionierelemente 36 angepaßt ist.

Bedingt durch Abmessungstoleranzen können die Kontakte 18 der Kontaktfahne 16 des Teilmoduls 10 gegen die Kontaktorgane 42 der Leiterplatte 40 vor der Montage der Leiterplatte 40 an der Schaltungsanordnung seitlich geringfügig versetzt sein. Dieser Versatz ist durch die Pfeile "a" verdeutlicht.

Wird die Leiterplatte 40 an der Schaltungsanordnung angeordnet, so wird der jeweilige Hilfsträger 28 durch die konischen Zentrierabschnitte 38 der stiftförmigen Positionierelemente 36 entsprechend seitlich verschoben, was . durch den Pfeil 46 angedeutet ist. Dabei kommen die Kontakte 18 der Kontaktfahne 16 und die Kontaktorgane 42 der den Teilmodulen 10 gemeinsamen Leiterplatte 40 genau deckungsgleich, d.h. genau zentriert, miteinander in Kontakt. Abessungstoleranzen werden also in einfacher Weise ausgeglichen, wenn die Leiterplatte 40 an der Schaltungsanordnung angeordnet und mit den Teilmoduln 10 kontaktiert wird.

Zur begrenzten Beweglichkeit der jeweiligen Hilfsträgers 28 steht von dessen Unterseite ein Ansatz 48 weg, der in eine Aussparung 50 hineinragt, die im Rahmen 24 ausgebildet ist.

Die Aussparung 50 ist im Rahmen 24 als Querschlitz ausgebildet, so dass der Hilfsträger 28 nicht nur in Längsrichtung des Rahmens 24 begrenzt beweglich ist, sondern außerdem auch senkrecht, d.h. quer, hierzu.

Mit der Bezugsziffer 30 sind in Figur 2 auch die vom Hilfsträger 28 wegstehenden Zapfen bezeichnet, die sich durch die Löcher 32 hindurch erstrecken, die in der zugehörigen Kontaktfahne 16 ausgebildet sind. In Figur 2 ist auf die Darstellung von Gewindebuchsen verzichtet worden, in welche Schrauben eingeschraubt werden, um die Leiterplatte 40 mit den Teilmodulen 10 richtig positioniert fest zu verbinden und einen genau zentrierten Kontakt zwischen den Kontakten 18 der Kontaktfahnen 16 und den Kontaktorganen 42 der Leiterplatte 40 herzustellen.

Figur 3 verdeutlicht schematisch in einer der Figur 2 ähnlichen Darstellung abschnittweise eine Ausbildung eines Teilmoduls 10 mit der zugehörigen, vom Teilmodul 10 beabstandet gezeichneten Leiterplatte 40, wobei zwischen dem Hilfsträger 28 und der zugehörigen Kontaktfahne 16 ein Polsterelement 52 vorgesehen ist, durch welches der Kontakt-Anpreßdruck zwischen den Kotakten 18 der Kontaktfahne 16 und den Kontaktorganen 42 der Leiterplatte 42 weiter verbessert wird, wenn die Leiterplatte 40 an der Schaltungsanordnung befestigt wird.

Gleiche Einzelheiten sind in den Figuren jeweils mit denselben Bezugsziffern bezeichnet, so dass es sich erübrigt, in Verbindung mit den Figuren alle Einzelheiten jeweils detailliert zu beschreiben.

### Bezugsziffernliste:

- 10: Teilmodul (einer Schaltungsanordnung)
- 12: Substrat (von 10)
- 14: Leiterbahnen (an 12)
- 16: Kontaktfahne (für 18)
- 18: Kontakte (an 16)
- 20: Gleichstrom-Lastanschlüsse (von 10)
- 22: Wechselstrom-Lastanschluß (von 10)
- 24: Rahmen (von 10 an 26 für 28)
- 26: Kühlkörper (von 10)
- 28: Hilfsträger (für 16)
- 30: Zapfen (an 28 für 16)
- 32: Löcher (in 16 bzw. 52 für 30)
- 34: Befestigungsorgan (an 28 für 40)
- 36: Positionierelemente (an 28 für 40)
- 38: Zentrierabschnitt (von 36)
- 40: Leiterplatte (für 10)
- 42: Kontaktorgane (an 40)
- 44: Loch (in 40 für 36)
- 46: Pfeil (bei 28)
- 48: Ansatz (an 28 in 50)
- 50: Aussparung (in 24 für 48)
- 52: Posterelement (zwischen 16 und 28)

## Patentansprüche

1. Schaltungsanordnung mit mindestens zwei Teilmoduln (10), die in einem Gehäuse nebeneinander angeordnet sind und mit einer Leiterplatte (40), wobei die Teilmodule Gleichstrom-Lastanschlüsse und einen Wechselstrom-Lastanschluss aufweisen, wobei jedes Teilmodul (10) ein Substrat (12) mit Leiterbahnen (16) und mindestens ein hierauf angeordnetes Halbleiterbauelement aufweist, und zur schaltgerechten Kontaktierung des mindestens einen Halbleiterbauelementes eine Verbindungseinrichtung vorgesehen ist, die mindestens eine Kontaktfahne (16) mit Kontakten (18) zur Kontaktierung mit Kontaktorganen (42) der Leiterplatte (40) aufweist, die den mindestens zwei Teilmoduln (10) zugeordnet ist, wobei jedes Teilmodul (10) einen das zugehörige Substrat (12) umschließenden Rahmen (24) aufweist, an dem mindestens ein Hilfsträger (28) in Rahmen-Längsrichtung begrenzt beweglich angeordnet ist, an dem die zugehörige Kontaktfahne (16) befestigt ist, wobei zur begrenzten Beweglichkeit des jeweiligen Hilfsträgers (28) von dessen Unterseite ein Ansatz (48) weg steht, der in eine Aussparung (50) hineinragt, die im Rahmen (24) als Querschlitz ausgebildet ist, wobei der mindestens eine Hilfsträger (28) mindestens ein Positionierelement (36) aufweist, das zur positionsgenauen Ausrichtung und Zentrierung der Kontakte (18) der entsprechenden Kontaktfahne (16) in Bezug zu den Kontaktorganen (42) der den Teilmoduln (10) gemeinsamen Leiterplatte (40) vorgesehen ist.

2. Schaltungsanordnung nach Anspruch 1,
**dadurch gekennzeichnet,**
**dass** die Kontaktfahne (16) am zugehörigen Hilfsträger (28) formschlüssig oder kraftschlüssig oder materialschlüssig befestigt ist.

3. Schaltungsanordnung nach Anspruch 1,
**dadurch gekennzeichnet,**
**dass** der mindestens eine Hilfsträger (28) am zugehörigen Rahmen (24) auch in Richtung senkrecht zur Rahmen-Längsrichtung begrenzt beweglich ist.

4. Schaltungsanordnung nach einem der Ansprüche 1 bis 3,
**dadurch gekennzeichnet,**
**dass** zwischen dem mindestens einen Hilfsträger (28) und der zugehörigen Kontaktfahne (16) des jeweiligen Teilmoduls (10) ein Polsterelement (52) vorgesehen ist.

5. Schaltungsanordnung nach Anspruch 1,
**dadurch gekennzeichnet,**
**dass** das mindestens eine Positionierelement (36) des jeweiligen Hilfsträgers (28) stiftförmig mit einem sich verjüngenden Zentrierabschnitt (38) ausgebildet ist.

6. Schaltungsanordnung nach einem der Ansprüche 1 bis 5,
**dadurch gekennzeichnet,**
**dass** der jeweilige Hilfsträger (28) zur Befestigung der Leiterplatte (40) mindestens ein Befestigungsorgan (34) aufweist.

## Claims

1. A circuit assembly with at least two sub-modules (10), which are arranged next to one another in a housing, and with a circuit board (40), wherein
the sub-modules have direct current load terminals and an alternating current load terminal, wherein
each sub-module (10) has a substrate (12) with conducting tracks (16) and at least one semiconductor component arranged on the substrate, and a connecting device is provided for purposes of making the correct circuit contacts with the at least one semiconductor component, which connecting device has at least one contact tab (16) with contacts (18) for purposes of making contact with contact bodies (42) of the circuit board (40), which is associated with the at least two sub-modules (10), wherein
each sub-module (10) has a frame (24) enclosing the related substrate (12), on which frame at least one auxiliary carrier (28) is arranged with limited mobility in the longitudinal direction of the frame, to which auxiliary carrier the related contact tab (16) is attached, wherein
for purposes of providing limited mobility for the respective auxiliary carrier (20) a lug projects from its lower face, which lug extends into a recess (50), which is designed as a transverse, slot in the frame (24), wherein
the at least one auxiliary carrier (28) has at least one positioning element (36), which is provided for purposes of accurate positioning alignment and centring of the contacts (18) of the corresponding contact tab (16) with reference to the contact bodies (42) of the contact board (40) that is common to the sub-modules (10).

2. The circuit assembly in accordance with Claim 1,
**characterised in that**,
the contact tab (16) is attached to the related auxiliary carrier (28) by means of a form fit, or a force fit, or a material bond.

3. The circuit assembly in accordance with Claim 1,
**characterised in that**,
the at least one auxiliary carrier (28) on the related frame (24) also has limited mobility in the direction at right angles to the longitudinal direction of the frame.

4. The circuit assembly in accordance with one of the Claims 1 to 3,
**characterised in that**,
a cushioning element (52) is provided between the at least one auxiliary carrier (28) and the related contact tab (16) of the respective sub-module (10).

5. The circuit assembly in accordance with Claim 1,
**characterised in that**,
the at least one positioning element (36) of the respective auxiliary carrier (28) is designed in the form of a pin with a tapering centring section (38).

6. The circuit assembly in accordance with one of the Claims 1 to 5,
**characterised in that**,
the respective auxiliary carrier (28) has at least one attachment body (34) for purposes of attaching the circuit board (40).

## Revendications

1. Ensemble de commutation comportant au moins deux sous-modules (10), qui sont disposés l'un à côté de l'autre dans un boîtier, et comportant une plaquette de circuits imprimés (40), les sous-modules comportant des raccords de charge à courant continu et un raccord de charge à courant alternatif, chaque sous-module (10) comportant un substrat (12) avec des pistes conductives (16) et au moins un composant semi-conducteur agencé sur celui-ci, et un dispositif de liaison étant prévu pour la mise en contact, adaptée à une commutation, dudit au moins un composant semi-conducteur, lequel dispositif de liaison comporte au moins une languette de contact (16) avec des contacts (18) pour la mise en contact avec des organes de contact (42) de la plaquette de circuits imprimés (40), laquelle est associée auxdits au moins deux sous-modules (10), chaque sous-module (10) comportant un cadre (24), qui délimite le substrat (12) correspondant et sur lequel est agencé, de manière mobile limitée dans le sens longitudinal du cadre, un support auxiliaire (28) sur lequel est fixée la languette de contact (16), et pour la mobilité limitée du support auxiliaire (28) respectif, la face inférieure de celui-ci est munie d'un ergot (48) saillant engagé dans une cavité (50) réalisée sous forme de fente transversale dans le cadre (24), ledit au moins un support auxiliaire (28) comportant au moins un élément de positionnement (36) qui est prévu pour orienter dans la bonne position et pour centrer les contacts (18) de la languette de contact (16) correspondante par rapport aux organes de contact (42) de la plaquette de circuits imprimés (40) commune aux sous-modules (10).

2. Ensemble de commutation selon la revendication 1, **caractérisé en ce que** la languette de contact (16) est fixée sur le support auxiliaire (28) correspondant par conjugaison de forme ou par force ou par adhérence de matière.

3. Ensemble de commutation selon la revendication 1, **caractérisé en ce que** ledit au moins un support auxiliaire (28) est mobile sur le cadre (24) correspondant, également de manière limitée dans la direction perpendiculaire au sens longitudinal du cadre.

4. Ensemble de commutation selon l'une quelconque des revendications 1 à 3, **caractérisé en ce qu'**un élément de rembourrage (52) est prévu entre ledit au moins un support auxiliaire (28) et la languette de contact (16) correspondante du sous-module (10) respectif.

5. Ensemble de commutation selon la revendication 1, **caractérisé en ce que** ledit au moins un élément de positionnement (36) du support auxiliaire (28) respectif est réalisé en forme de téton avec une zone de centrage (38) effilée.

6. Ensemble de commutation selon l'une quelconque des revendications 1 à 5, **caractérisé en ce que** le support auxiliaire (28) respectif comporte au moins un organe de fixation (34) pour la fixation de la plaquette de circuits imprimés (40).
